Europäisches Patentamt

(19) European Patent Office

Office européen des brevets

(11) Numéro de publication: **0192519**
**B1**

(12) **FASCICULE DE BREVET EUROPEEN**

⑮ · Date de publication du fascicule du brevet:
**31.05.89**

(21) Numéro de dépôt: **86400147.4**

(22) Date de dépôt: **24.01.86**

(51) Int. Cl.⁴: **H05K 7/18**

(54) Dispositif de montage d'une platine support dans un coffret de distribution.

(30) Priorité: **29.01.85 FR 8501229**

(43) Date de publication de la demande:
**27.08.86 Bulletin 86/35**

(45) Mention de la délivrance du brevet:
**31.05.89 Bulletin 89/22**

(84) Etats contractants désignés:
**AT BE CH DE GB IT LI NL SE**

(56) Documents cités:
**DE-A- 2 013 385**
**DE-A- 3 135 224**
**DE-C- 3 344 598**
**US-A- 3 279 871**

(73) Titulaire: **SAREL APPAREILLAGE ELECTRIQUE Société anonyme, Route de Phalsbourg, F-67260 Sarre Union(FR)**

(72) Inventeur: **Ber, Michel, Résidence Bruant Avenue du Général Leclerc, F-57400 Sarrebourg(FR)**
Inventeur: **Henry, Jacques, 29, rue du Brotsch, F-67700 Otterswiller(FR)**

(74) Mandataire: **Lerner, François, 5, rue Jules Lefèbvre, F-75009 Paris(FR)**

## Description

L'invention se rapporte à un dispositif pour le montage à différents niveaux de profondeur dans une armoire ou un coffret de distribution d'une platine support.

Un problème qui se pose fréquemment pour l'équipement des armoires et coffrets de distribution, en particulier pour des installations électriques et életroniques, est de disposer d'une ou plusieurs platines supports devant recevoir les différents appareils, qui s'y fixent, au niveau de profondeur désiré de l'armoire, voir par ex. DE-C-3 344 598.

Par exemple, le fond de l'armoire reçoit une platine de fond sur laquelle sont posés certains appareillages, et l'on désire disposer à un niveau supérieur plus près de l'ouverture une autre platine qui recevra d'autres appareillages, de distribution et/ou de commande.

Pour résoudre ces problèmes, on connaît déjà des boîtiers ou armoires équipés de moyens tels que des vis ou goujons fixés, par exemple soudés sur le fond du coffret, et sur lesquels goujons ou vis on pourra venir fixer une platine de fond ; ces même coffrets comportent également, vers leurs angles, quatre profilés, par exemple formés en crémaillère, se faisant face deux à deux et sur lesquels profilés on peut venir fixer à tout niveau de profondeur désiré une platine support intermédiaire.

Cette disposition présente, néanmoins, un certain nombre d'inconvénients, tels notamment que les suivants :

a) le coffret ou l'armoire est équipé d'office de quatre crémaillères, ce qui augmente le prix de revient de façon inconsidérée pour l'utilisateur qui ne désire pas employer de platine support placée à un niveau intermédiaire ;

b) le positionnement des quatre profilés contre les parois internes du boîtier réduit l'espace d'accès et le volume intérieur utile du coffret.

L'invention a pour objet d'éviter les difficultés sus-mentionnées.

A cet effet, un dispositif pour le montage à différents niveaux de profondeur dans une armoire ou un coffret d'une platine support, du type comprenant des profilés disposés sensiblement parallèlement à la direction de profondeur de l'armoire et dans les angles internes pour recevoir à l'emplacement choisi des organes de fixation de la platine vers ces angles, se caractérise selon l'invention en ce que lesdits profilés sont fixés de façon amovible entre le fond du coffret et la face d'ouverture du coffret entre deux pattes fixées de façon amovible par des moyens tels qu'écrous et vis ne nécessitant, pour l'utilisateur, aucune opération de soudage ou de perçage.

Avantageusement, vers l'ouverture du coffret, l'une des vis utilisée traverse un orifice formé dans le rebord d'ouverture pour le montage d'une des vis de fixation d'une charnière de montage de la porte. En outre, vers le fond du coffret, les vis utilisées sont celles qui servent au montage de la platine sur le fond du coffret lorsqu'une telle platine de fond est utilisée.

Il apparaît que de cette façon, le coffret peut être équipe très facilement et uniquement à volonté des profilés qui permettront le montage aisé à tout niveau désiré de profondeur d'une platine support, si l'utilisateur choisit une telle option de montage. En outre, cette option de montage peut ne pas être commandée au départ, mais seulement ultérieurement lorsque éventuellement le besoin s'en fait sentir. De surcroît, le dispositif de l'invention permet le montage des profilés supports par des opérations extrêmement simples tels que le vissage et dévissage d'un écrou, sans dépose de la porte du coffret.

Selon une autre caractéristique de l'invention, les profilés sont orientés avec leur plan médian confondu avec le plan bissecteur de l'angle correspondant du coffret. Une telle disposition dans l'angle contrastant avec la disposition antérieurement utilisée selon laquelle les profilés étaient soudés contre des parois du coffret réduit au strict minimum l'encombrement de ces profilés dans le coffret et ne réduit pratiquement pas la surface d'utilisation et d'accès au coffret.

L'invention et sa mise en oeuvre apparaîtront plus clairement à l'aide de la description qui va suivre faite en référence aux dessins annexés dans lesquels :

- la figure 1 montre en vue perspective, avec arrachement, un angle d'un coffret équipé selon l'invention avec la porte du coffret en position d'ouverture ;
- la fugure 2 montre en vue perspective et éclatée la configuration et disposition respectives des pièces essentielles coopérant à la fixation dans le coin du cofret d'un profilé ;
- la figure 3 est une vue de devant du fond du coffret, faite avec arrachements, et sensiblement à un niveau de coupe se situant à mi-profondeur du coffret ;
- la figure 4 est une vue en plan faite avec arrachements face à l'ouverture du coffret, porte enlevée ;
- la figure 5 montre une vue de face de la patte de fond utilisée pour la fixation du profilé ;
- la figure 6 est une vue en coupe faite selon le plan VI-VI de la figure 5 ;
- la figure 7 est une vue de face de l'autre patte de fixation du profilé, côté de l'ouverture de la porte, cette vue étant faite pependiculairement au plan de la face repérée VII dans cette figure ;
- la figure 8 est une vue semblable à celle de la figure 7, mais faite perpendiculairement au plan repéré VIII de cette pièce ;
- la figure 9 est une vue par dessus du coin du coffret montrant le positionnement relatif de la patte côté ouverture du coffret, du profilé et de l'angle du coffret.

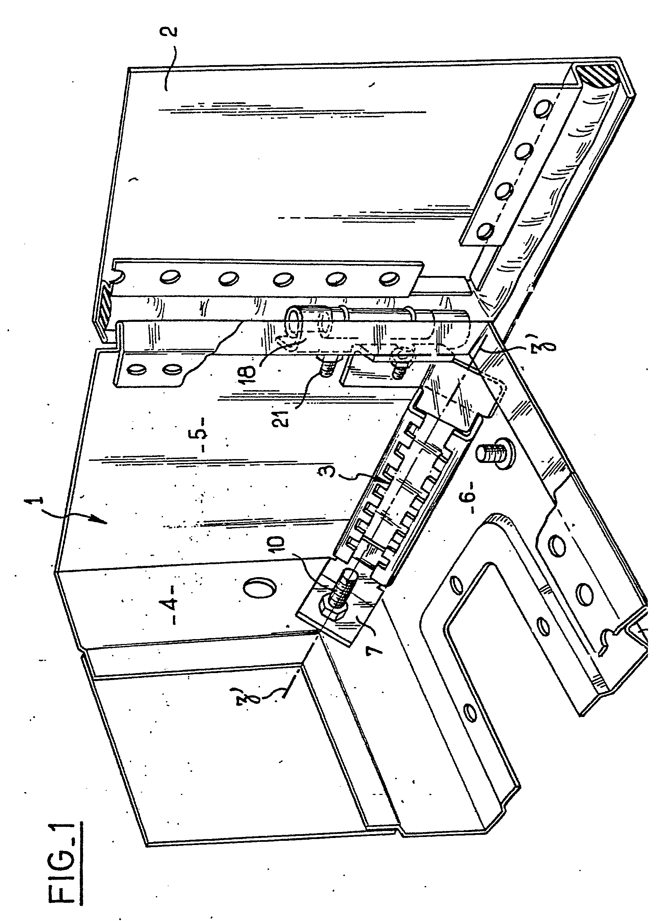

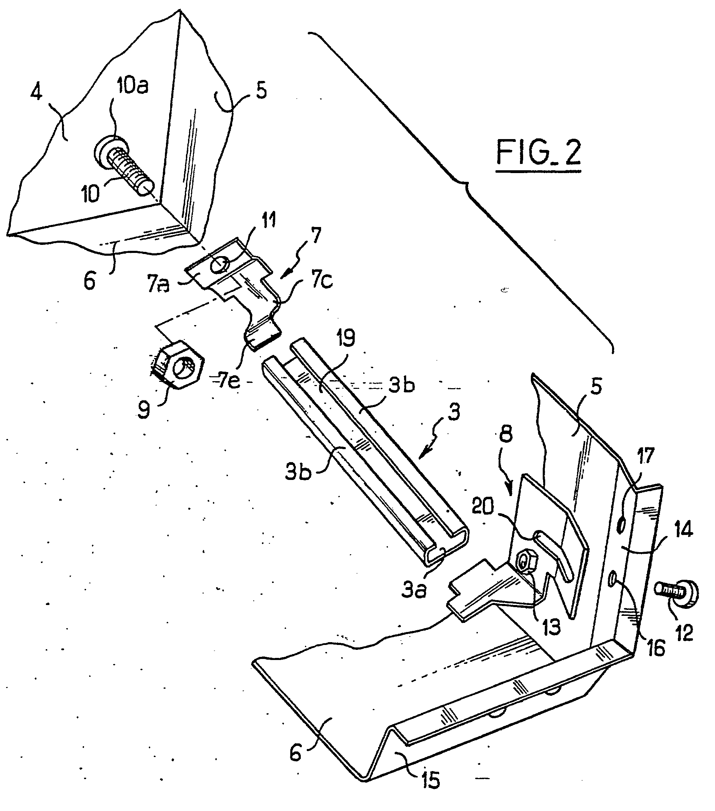

Comme il apparaît aux dessins, et notamment des figures 1 et 2, on équipe un coffret composé essentiellement d'un boîtier 1 obturable par une porte 2 en chacun de ses angles d'un profilé 3 qui s'étend parallèlement à la direction z' z de profondeur du coffret. A la figure 1 on aperçoit une partie 4 du fond et les parties adjacentes 5, 6 de parois, ces trois parties 4, 5, 6 formant un trièdre dont l'angle forme le coin de fond du coffret.

Comme il apparaît plus clairement de la vue éclatée de la figure 2, la fixation du profilé 3, parallèlement à la direction z'z se fait essentiellement au moyen de deux pattes respectivement 7 et 8. La patte 7 est fixée sur la paroi de fond 4 du coffret au moyen d'un écrou 9 qui se visse sur une vis ou un goujon 10 soudé sur le fond 4, la patte 7 comportant, à cet effet, un orifice 11 dans lequel est reçu le goujon 10.

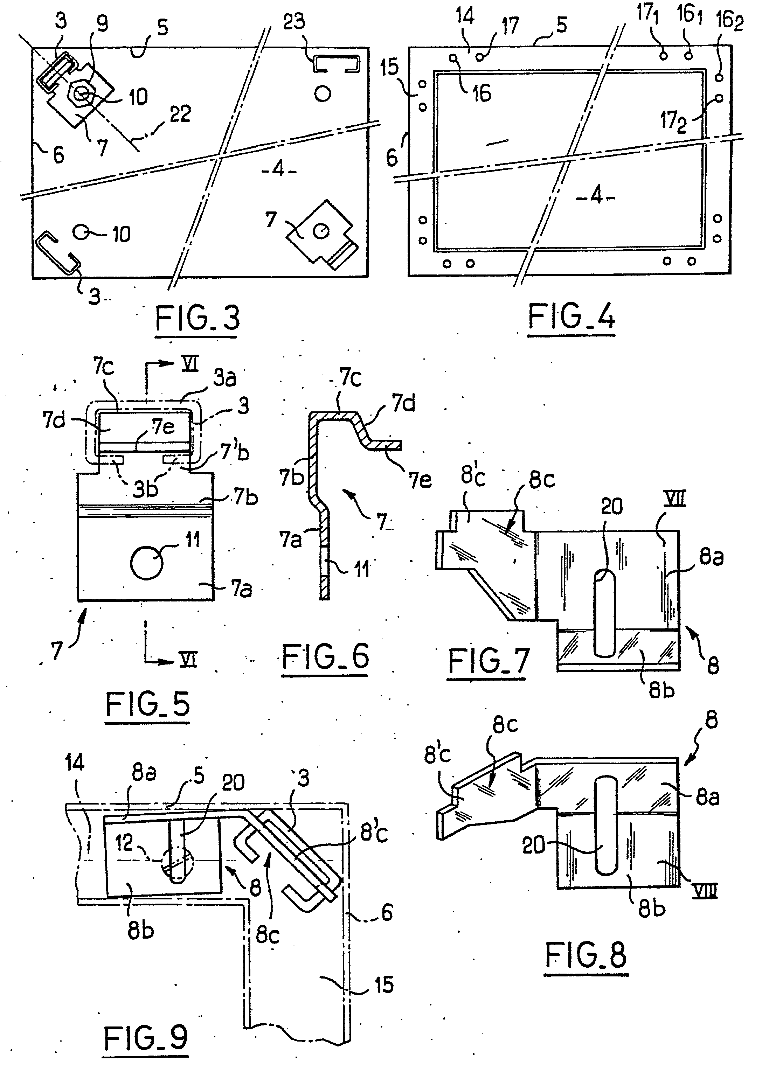

La patte 8, côté ouverture du coffret, est fixée quant à elle, sous l'angle rentrant correspondant bordant l'ouverture du coffret. De façon plus précise, et comme il apparaît plus clairement des figures 2 et 9, la patte 8 vient se fixer au moyen d'une vis 12 et d'un écrou 13 contre une partie de la paroi 5 du coffret et une partie du rebord 14 rentrant formant la bordure d'ouverture du coffret pour la fixation et l'adaptation de la porte 2.

Pour permettre cette fixation, la bordure 14 comporte un orifice 16. Cet orifice 16 n'est autre que l'un des deux orifices 16, 17, servant à la fixation de la charnière 18 de support et de fixation de la porte d'ouverture 2 sur le boîtier 1.

Comme il apparaît clairement à la figure 4, des orifices tels que 16, 17 sont prévus en chaque angle du coffret et de chaque côté de l'angle, tel que repéré $16_1$ $17_1$, $16_2$ $17_2$... L'intérêt de la prévision de tels jeux d'orifices est de permettre, de façon en soi connue, le montage de la porte 2 sur le boîtier 1 en toute position appropriée pour avoir des ouvertures à gauche ou à droite et permettre le positionnement du coffret avec sa plus grande dimension dans la direction verticale ou dans la direction horizontale. Les orifices non utilisés sont obturés par des bouchons, tout ceci étant classique. Par contre, il apparaît que selon l'invention, on peut utiliser l'un des orifices servant au montage de la charnière pour venir fixer, de façon amovible, un profilé 3 dans l'angle correspondant du boîtier, si l'on désire utiliser un tel profilé pour l'adaptation de platines supports à différents niveaux de profondeur dans le boîtier.

On va décrire, maintenant, plus en détail la conformation particulière des pattes 7 et 8 dans l'exemple de réalisation illustré et ce en faisant référence essentiellement aux figures 5 à 8.

En se référant, tout d'abord aux figures 5 et 6, la patte 7 présente une partie 7a, 7b, conformée de façon à venir s'appliquer et porter convenablement contre le fond 4 du boîtier, en tenant compte de la légère surélévation 10a (figure 2) au point de soudure de la vis ou du goujon 10 sur le fond 4. La partie 7b se rétrécie ensuite au niveau repéré 7'b, de façon à présenter une largeur compatible avec son introduction dans le profilé 3. La partie 7b se continue ensuite par une partie en crochet 7c, 7d, 7e, formant un bec recourbé qui s'élève à partir du fond et porte vers sa base 7c contre la paroi la plus extérieure 3a du profilé 3 et vers son extrémité haute libre 7e contre la paroi 3b, la plus intérieure du profilé, paroi dans laquelle est formée la lumière 19 du profilé 3. (Voir également figure 2)

On décrira maintenant, en se reportant aux figures 7 et 8, la conformation de la patte 8.

Dans son ensemble, cette patte, comporte essentiellement trois faces 8a (repérée également VII à la figure 7), 8b (repérée VIII à la figure 8), et 8c formant une sorte de trièdre. La face 8b vient se placer à l'intérieur du coffret contre la bordure 14 (figure 2) formant bordure d'ouverture du coffret. La face 8a, qui relie les deux faces 8b et 8c de la patte 8, vient porter contre la face adjacente 5 du coffret. La patte 8c est positionnée dans l'angle correspondant du coffret de façon à recevoir et bloquer, par son extrémité rétrécie 8'c le profilé 3. Une lumière 20 s'étend sur les deux faces 8a, 8b de la patte 8 permettant l'insertion de la vis 12, pour la fixation de la patte après serrage de l'écrou 13 à l'intérieur du coffret.

On décrira maintenant brièvement le montage du profilé 3.

Si l'on veut fixer un profilé 3 dans l'angle d'un coffret, il suffit d'effectuer les opérations successives suivantes :

-on met en place une patte 7 sur la vis 10 et l'on serre l'écrou 9 correspondant ;

- on enfile ensuite le profilé 3 par dessus la patte 7, le profilé venant se bloquer, comme il a été expliqué au moment de la description des figures 5 et 6 contre les faces 7c et 7e de la partie en bec relevée de cette patte ;

- s'il s'agit d'un ensemble dans lequel est montée une charnière 18 de fixation de la porte 2, on dévisse le seul écrou 13 de la vis 12 correspondant à l'orifice 16, ce qui se fait sans dépose de la porte et sans enlèvement de la charnière qui restent maintenues par la vis complémentaire 21 (figure 1) vissée dans l'orifice 17 adjacent ; s'il s'agit d'un angle où il n'y a pas de charnière de porte, on enlève simplement le bouchon fermant l'orifice 16 correspondant, et l'on met en place une vis 12 ;

- on positionne et engage correctement la patte 8 sous l'angle d'ouverture du boîtier en faisant en sorte d'engager la lumière 20 par dessus la vis 12 en place dans l'orifice 16. Simultanément, on guide et engage l'extrémité correspondante avant du profilé 3 sur la saillie 8'c de la patte 8 ;

- on serre l'écrou 13.

Le profilé est en place.

On note, en se référant aux dessins, et particulièrement à la figure 3, que le plan médian du profilé 3 est confondu avec le plan bissecteur 22 de l'angle dans lequel il est monté. Avec un tel positionnement, en utilisant un profilé de section sensiblement rectangulaire applati avec une face dirigée vers l'intérieur du coffret comportant une lumière 19, on libère la surface d'utilisation maximale à l'intérieur du coffret, ce qui n'était pas le cas lorsqu'on utilisait des profilés soudés contre une paroi du boîtier tel qu'il a été schématisé en 23 à la figure 3.

Il en résulte que l'invention est d'utilisation particulièrement souple et pratique.

Bien qu'on n'ait décrit les opérations de mise en place que d'un seul profilé 3, il est évident, que dans la pratique, on montera en chaque angle du coffret un tel profilé en utilisant donc quatre profilés et quatre jeux de pattes identiques 7,8.

La forme et configuration du profilé 3 pourront être diverses, comme il est bien connu, la lumière 19 pouvant n'être formée que sur une partie utile de la longueur du profilé, pouvant être formée en crémaillère ou pouvant être remplacée par une série d'orifices, cela en fonction des éléments correspondants de fixation de la platine qui viendra s'adapter sur ces profilés.

De même, on peut réaliser en une seule pièce le profilé 3 et une patte 7 ou 8 ou même les deux pattes 7 et 8. Dans ce cas, le profilé est un peu plus compliqué mais le montage est simplifié.

## Revendications

1. - Dispositif pour le montage à différents niveaux de profondeur dans une armoire ou un coffret d'une platine support, du type comprenant des profilés disposés sensiblement parallèlement à la direction de profondeur de l'armoire et dans les angles internes pour recevoir à l'emplacement choisi des organes de fixation de la platine vers ces angles, caractérisé en ce que lesdits profilés (3) sont fixés de façon amovible entre le fond (4) du coffret (1) et la face d'ouverture du coffret entre deux pattes (7, 8) fixées de façon amovible par des moyens tels qu'écrous et vis (9, 10, 12, 13) ne nécessitant pour l'utilisateur aucune opération de soudage ou de perçage.

2. - Dispositif selon la revendication 1, caractérisé en ce que, vers l'ouverture du coffret, l'une des vis (12) utilisée, traverse un orifice (16) formé dans le rebord d'ouverture (14), pour le montage des vis de fixation d'une charnière (18) de montage de la porte (2).

3. - Dispositif selon la revendication 1 ou la revendication 2, caractérisé en ce que vers le fond (4) du coffret, les vis (10) utilisées sont celles qui servent au montage de la platine sur le fond du coffret lorsqu'une telle platine de fond est utilisée.

4. - Dispositif selon l'une des revendications précédentes, caractérisé en ce que lesdits profilés (3) sont orientés avec leur plan médian confondu avec le plan bissecteur (22) de l'angle correspondant du coffret.

5. - Dispositif selon la revendication 4, caractérisé en ce que lesdits profilés (3) ont une section sensiblement rectangulaire applatie, la face dirigée vers l'intérieur du coffret, comportant une lumière (19) centrale s'étendant sur sensiblement toute la longueur du profilé.

6. - Dispositif selon la revendication 5, caractérisé en ce que ladite lumière est formée en crémaillère.

7. - Dispositif selon l'une des revendications précédentes, caractérisé en ce que la patte (7) de fond présente un bec recourbé qui s'élève à partir du fond et porte vers sa base (7c) contre la paroi la plus extérieure (3a) du profilé (3) et vers son extrémité haute libre (7e) contre la paroi la plus intérieure (3b) du profilé (3).

8. - Dispositif selon l'une des revendications précédentes, caractérisé en ce que la patte (8) située vers l'ouverture du coffret forme une sorte de trièdre qui s'adapte par deux de ses faces (8a, 8b) dans l'angle interne correspondant d'ouverture du coffret (5, 14) et dont la troisième face (8c) se termine par une saillie (8'c) sur laquelle s'engage et se verrouille l'extrémité avant du profilé (3) correspondant.

9. - Dispositif selon l'une des revendications précédentes, caractérisé en ce que le profilé (3) forme une seule pièce avec la ou les pattes (7, 8).

## Patentansprüche

1. Vorrichtung zur Halterung einer Trägerplatte in verschiedenen Tiefenebenen in einem Schrank oder einem Gehäuse, umfassend Profile, die im wesentlichen parallel zur Richtung der Schranktiefe und in den Innenecken angeordnet sind, um an gewünschter Stelle Befestigungsmittel der Platte gegen die Ecken aufzunehmen, dadurch gekennzeichnet, daß die Profile (3) lösbar zwischen der Rückwand (4) des Gehäuses (1) und der Öffnungsfläche des Gehäuses zwischen zwei Laschen (7, 8) befestigt sind, die durch Mittel wie Mutter und Schraube (9, 10, 12, 13) lösbar befestigt sind, so daß für den Benutzer jegliches Schweißen oder Bohren überflüssig ist.

2. Vorrichtung nach Anspruch 1, dadurch gekennzeichnet, daß zu der Öffnung des Gehäuses hin eine der verwendeten Schrauben (12) ein in der Kante der Öffnung (14) gebildetes Loch (16) zur Halterung von Befestigungsschrauben eines Scharniers (18) des Lagers der Tür (2) durchgreift.

3. Vorrichtung nach Anspruch 1 oder Anspruch 2, dadurch gekennzeichnet, daß zur Rückwand (4) des Gehäuses hin die verwendeten Schrauben (10) diejenigen sind, die zur Halterung der Platte an der Rückwand des Gehäuses bei Verwendung einer solchen Rückwandplatte dienen.

4. Vorrichtung nach einem der vorangehenden Ansprüche, dadurch gekennzeichnet, daß die Profile (3) mit ihrer Mittelebene fluchtend mit der Halbierungsebene (22) des entsprechenden Winkels des Gehäuses ausgerichtet sind.

5. Vorrichtung nach Anspruch 4, dadurch gekennzeichnet, daß die Profile (3) einen im wesentlichen rechtwinklig flachen Querschnitt aufweisen, wobei die gegen das Gehäuseinnere gerichtete Fläche einen zentralen, im wesentlichen über die Gesamtlänge des Profils sich erstreckenden Schlitz (19) umfaßt.

6. Vorrichtung nach Anspruch 5, dadurch gekennzeichnet, daß der Schlitz mit einer Zähnung ausgebildet ist.

7. Vorrichtung nach einem der vorangehenden Ansprüche, dadurch gekennzeichnet, daß die Lasche (7) der Rückwand einen gekrümmten Ansatz aufweist, der sich von der Rückwand her erhebt und mit seinem Basisteil (7c) gegen die äußerste Wandung (3a) des Profils (3) und mit seinem oberen freien Ende (7e) gegen die innerste Wandung (3b) des Profils (3) anliegt.

8. Vorrichtung nach einem der vorangehenden Ansprüche, dadurch gekennzeichnet, daß die zu der Gehäuseöffnung hin angeordnete Lasche (8) nach Art eines Dreiflachs gebildet ist, der sich mit zwei seiner Flächen (8a, 8b) in einen entsprechenden Innenwinkel der Öffnung des Gehäuses (5, 14) einfügt und dessen dritte Fläche (8c) in einem Vorsprung (8'c) endet, an dem das vordere Ende des entsprechenden Profils (3) angreift und verriegelt ist.

9. Vorrichtung nach einem der vorangehenden Ansprüche, dadurch gekennzeichnet, daß das Profil (3) einstückig mit der oder den Laschen (7, 8) ausgebildet ist.

## Claims

1. A device for mounting at different levels in a case or cabinet a support plate of the type comprising profile members disposed substantially parallel with the direction of depth of the cabinet and in the interior corners to receive at the selected position members for fixing the plate into the said corners, characterised in that the said profile members (3) are removably mounted between the back (4) of the case (1) and the opening face of the cabinet (1), between two lugs (7, 8) removably fixed by means such as nuts and bolts (9, 10, 12, 13), requiring no welding or drilling on the part of the user.

2. A device according to Claim 1, characterised in that, towards the opening of the cabinet, one of the bolts (12) used passes through an orifice (16) formed in the returned edge (14) around the opening in order to mount the fixing bolts of a hinge (18) for mounting the door (2).

3. A device according to Claims 1 or 2, characterised in that towards the back (4) of the cabinet the bolts (10) used are those which serve to mount the plate on the back of the cabinet when such a back plate is used.

4. A device according to one of the preceding Claims, characterised in that the said profile members (3) are orientated that their median plane coincides with the plane (22) which bisects the corresponding corner of the cabinet.

5. A device according to Claim 4, characterised in that the said profile members (3) have a substantially flattened rectangular cross-section, the face which is towards the interior of the cabinet comprising a central aperture (19) which extends over substantially the length of the profile member.

6. A device according to Claim 5, characterised in that the said aperture is formed like a rack.

7. A device according to any one of the preceding Claims, characterised in that the back lug (7) has a curved leading edge which is raised off the back and bears, towards its bottom (7c) against the outermost wall (3a) of the profile member (3) and towards its free top end (7e) against the innermost wall (3b) of the profile member (3).

8. A device according to any one of the preceding Claims, characterised in that the lug (8) situated towards the opening of the cabinet forms a kind of trihedron by two of whose faces (8a, 8b) it is fitted into the corresponding inside corner of the opening in the cabinet (5, 14), while the third face (8c) ends in a projection (8'c) over which the front end of the corresponding profile member (3) engages and is locked.

9. A device according to any one of the preceding Claims, characterised in that the profile member (3) forms one single piece together with the lug or lugs (7, 8).

FIG_1

FIG_2

FIG_3

FIG_4

FIG_5

FIG_6

FIG_7

FIG_8

FIG_9